# EUROPEAN PATENT APPLICATION

(11) **EP 2 698 823 A1**
(43) Date of publication of application: **19.02.2014**
(21) Application number: 12770971.5
(22) Date of filing: 13.04.2012
(51) Int. Cl.: H01L 29/47, H01L 21/205, H01L 21/338, H01L 29/06, H01L 29/15, H01L 29/778, H01L 29/812, H01L 29/872

(54) **SEMICONDUCTOR DEVICE**

(30) Priority: 15.04.2011 JP 2011091332
(71) Applicant: Advanced Power Device Research Association, Yokohama-shi, Kanagawa 220-0073 (JP)
(72) Inventor: UTSUMI, Makoto, Yokohama-shi, Kanagawa 220-0073 (JP); KATOU, Sadahiro, Yokohama-shi, Kanagawa 220-0073 (JP); IWAMI, Masayuki, Yokohama-shi, Kanagawa 220-0073 (JP); KOKAWA, Takuya, Yokohama-shi, Kanagawa 220-0073 (JP)
(74) Representative: Horn Kleimann Waitzhofer
(86) International application number: PCT/JP2012/002597
(87) International publication number: WO 2012/140915

(57) **Abstract**

A semiconductor device includes a substrate, a channel layer that is formed above the substrate, where the channel layer is made of a first nitride series compound semiconductor, a barrier layer that is formed on the channel layer, a first electrode that is formed on the barrier layer, and a second electrode that is formed above the channel layer. Here, the barrier layer includes a block layers and a quantum level layer. The block layer is formed on the channel layer and made of a second nitride series compound semiconductor having a larger band gap energy than the first nitride series compound semiconductor, and the quantum level layer is made of a third nitride series compound semiconductor having a smaller band gap energy than the second nitride series compound semiconductor, and has a quantum level formed therein.

## Description

### BACKGROUND

### 1. TECHNICAL FIELD

The present invention relates to a semiconductor device.

### 2. RELATED ART

A known heterojunction field-effect transistor (HFET) has a multilayered film interposed between a channel layer made of gallium nitride (GaN), which is a nitride series compound semiconductor, and a barrier layer made of AlGaN, which is also a nitride series compound semiconductor, as disclosed in, for example, Japanese Patent Application Publication No. 2005-354101. The multilayered film is formed by stacking GaN layers and AlN layers to a thickness that does not create a quantum level.

When an AlN layer having a thickness of 2 nm is formed between the channel layer and the barrier layer, the two-dimensional electron gas can be prevented from being spreading to the barrier layer. This can enhance the carrier mobility. However, crystal dislocations occur at the heterojunctions between the channel layer made of GaN, the AlN layers included in the multilayered film, the GaN layers included in the multilayered film, and the barrier layer made of AlGaN. This leads to an increase in the number of dislocations that penetrate through the barrier layer. Since the dislocations provide current paths, the leakage current between the electrode formed on the barrier layer and the channel layer consequently increases.

Furthermore, an AlN layer inserted between the channel layer and the barrier layer increases the contact resistance between the ohmic electrode formed on the barrier layer and the channel layer. As discussed above, there were difficulties in achieving low sheet resistance by increasing the carrier mobility while also reducing the leakage current and the contact resistance of the ohmic electrode.

### SUMMARY

A first aspect of the innovations may include a semiconductor device including a substrate, a channel layer that is provided above the substrate, where the channel layer is made of a first nitride series compound semiconductor, a barrier layer that is formed on the channel layer, a first electrode that is formed on the barrier layer, and a second electrode that is formed above the channel layer. Here, the barrier layer includes a block layer and a quantum level layer. The block layer is formed on the channel layer and made of a second nitride series compound semiconductor having a larger band gap energy than the first nitride series compound semiconductor, and the quantum level layer is formed on the block layer, made of a third nitride series compound semiconductor having a smaller band gap energy than the second nitride series compound semiconductor, and has a quantum level formed therein.

The summary clause does not necessarily describe all necessary features of the embodiments of the present invention. The present invention may also be a sub-combination of the features described above. The above and other features and advantages of the present invention will become more apparent from the following description of the embodiments taken in conjunction with the accompanying drawings.

### BRIEF DESCRIPTION OF THE DRAWINGS

Fig. 1 is a cross-sectional view of a Schottky barrier diode (SBD) relating to a first embodiment of the present invention.
Fig. 2 shows the photoluminescence spectrum of a barrier layer.
Fig. 3 is a cross-sectional view of a SBD relating to a second embodiment of the present invention.
Fig. 4 is a cross-sectional view of a SBD relating to a third embodiment of the present invention.
Fig. 5 is a cross-sectional view of a HFET relating to a fourth embodiment of the present invention.

### DESCRIPTION OF EXEMPLARY EMBODIMENTS

Hereinafter, some embodiments of the present invention will be described. The embodiments do not limit the invention according to the claims, and all the combinations of the features described in the embodiments are not necessarily essential to means provided by aspects of the invention.

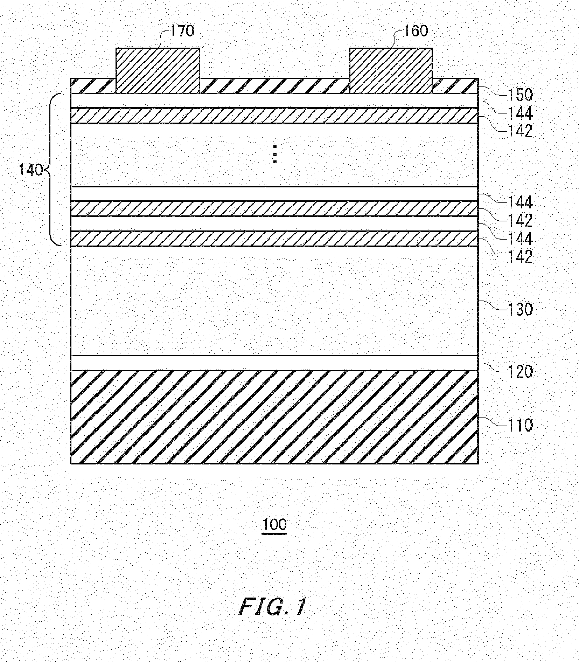

Fig. 1 is a cross-sectional view of a Schottky barrier diode (SBD) 100 relating to a first embodiment of the present invention. The SBD 100 includes a substrate 110, a buffer layer 120, a channel layer 130, a barrier layer 140, an insulation layer 150, an ohmic electrode 160, and a Schottky electrode 170.

The channel layer 130 is formed above the substrate 110 and is made of a nitride series compound semiconductor. The channel layer 130 may be made of GaN. The channel layer 130 may be made of GaN doped with impurities or non-doped GaN. The channel layer 130 has a thickness of, for example, 1000 nm. The barrier layer 140 is formed on the channel layer 130 by repeatedly stacking block layers 142 and quantum level layers 144. The block layers 142 are each made of a nitride series compound semiconductor that has a larger band gap energy than the nitride series compound semiconductor of the channel layer 130. The block layers 142 may be made of AlN. The quantum level layers 144 are each made of a nitride series compound semiconductor that has a smaller band gap energy than the nitride series compound semiconductor of the block layer 142. The quantum level layers 144 may be made of GaN.

On the channel layer 130, one of the block layers 142 may be formed. The heterojunction between the channel layer 130 and the barrier layer 140 generates a two-dimensional electron gas at the interface between the barrier layer 140 and he channel layer 130. When the block layer 142, which has a large band gap energy, is in contact with the channel layer 130, the two-dimensional electron gas of the channel layer 130 can be prevented from spreading to the barrier layer 140. This can increase the carrier mobility in the channel layer 130.

The quantum level layers 144 are formed on the block layers 142,. By adjusting the thicknesses of the block layers 142 and the quantum level layers 144 so that the block layers 142 and the quantum level layers 144 form a well potential, a quantum level is formed in the quantum level layers 144. Since the carriers are propagated through the quantum levels formed in the quantum level layers 144, lower contact resistance is formed between the channel layer 130 and the ohmic electrode 160. Furthermore, since the block layers 142 are thinly formed, a smaller number of dislocations are formed in the block layers 142. This reduces the leakage current flowing between the Schottky electrode 170 and the channel layer 130. Additionally, since the block layers 142 are thinly formed, lower contact resistance is formed between the ohmic electrode 160 and the channel layer 130.

The substrate 110 may be a sapphire substrate. Alternatively, the substrate 110 may be a Si substrate, a SiC substrate, a GaN substrate, or any other substrate on which a nitride series compound semiconductor layer can be formed.

The buffer layer 120 may be interposed between the substrate 110 and the channel layer 130. The buffer layer 120 may be a nitride series compound semiconductor. For example, the buffer layer 120 may be an AlN layer, a GaN layer, an AlGaN layer or a multilayered film formed by stacking these layers. The buffer layer 120 has a thickness of, for example, 20 nm. When the substrate 110 is a substrate on which a nitride series compound semiconductor layer with high crystallinity can be formed, the buffer layer 120 may be omitted so that the channel layer 130 may be formed on the substrate 110.

The buffer layer 120, the channel layer 130, the block layers 142, and the quantum level layers 144 may be formed using MOCVD. For example, when the channel layer 130 or the quantum level layers 144 are formed, the substrate 110 is placed within a MOCVD apparatus and trimethylgallium (TMGa) and ammonia (NH₃) are introduced into the chamber of the MOCVD apparatus so that GaN is epitaxially grown. When the buffer layer 120 or the block layers 142 are formed, trimethylaluminum (TMA1) and NH3 are introduced into the chamber of the MOCVD apparatus so that AlN is epitaxially grown.

In another embodiment, all or some of the buffer layer 120, the channel layer 130, the block layers 142, and the quantum level layers 144 may be formed by hydride vapor phase epitaxy (HVPE) or molecular beam epitaxy (MBE). The block layers 142 may be made of Al_{X}Ga_{1-X}N (0 < X < 1).

The insulation layer 150 is formed on part of the barrier layer 140. The insulation layer 150 may be made of an insulating material. For example, the insulation layer 150 is formed by a silicon oxide film. Alternatively, the insulation layer 150 may be formed by a silicon nitride film. The insulation layer 150 may be formed in such a manner that a layer of insulating material may be first formed on the entire surface of the barrier layer 140 and openings may be then formed by removing portions of the layer of insulating material in which the ohmic electrode 160 and the Schottky electrode 170 are to be formed. Here, the insulation layer 150 may be formed using CVD and photolithography.

The ohmic electrode 160 may be formed on the barrier layer 140 in the opening in the insulation layer 150 that has been formed by removing the insulation layer 150. The ohmic electrode 160 is made of a material that forms an ohmic contact with the channel layer 130. The material for the ohmic electrode 160 contains, for example, Ti. The ohmic electrode 160 may be formed by stacking, on the barrier layer 140, a Ti layer, an Al layer, and an Au layer in the stated order.

The Schottky electrode 170 may be formed on the barrier layer 140 in the opening in the insulation layer 150 that has been formed by removing the insulation layer 150. The ohmic electrode 160 and the Schottky electrode 170 may be spaced away from each other with a predetermined distance therebetween. The Schottky electrode 170 is made of a material that forms a Schottky contact with the channel layer 130. The material for the Schottky electrode 170 contains, for example, Ni. The Schottky electrode 170 may be formed by stacking, on the barrier layer 140, an Ni layer and an Au layer in the stated order. The ohmic electrode 160 and the Schottky electrode 170 can be formed using sputtering and the lift-off method, but the forming method of the ohmic electrode 160 and the Schottky electrode 170 is not limited to such.

Table 1 below shows the sheet resistance, carrier mobility, carrier density contact resistance and leakage current of the SBD 100 when the barrier layer 140 of the SBD 100 is formed by stacking the GaN quantum level layers 144 and the AlN block layers 142. The ohmic electrode 160 and the Schottky electrode 170 each occupied an area of 0.02 mm². The distance between the ohmic electrode 160 and the Schottky electrode 170 was 0.01 mm. The contact resistance was measured using the ohmic electrode 160 based on a transmission line model. A voltage of -50 V was applied to the Schottky electrode 170, and the currents flowing between the ohmic electrode 160 and the Schottky electrode 170 were measured as the leakage current.

The thicknesses of the block layers 142 and the quantum level layers 144 were measured using X-ray diffraction. In Table 1, the number of repetitions, which is represented by "R," indicates the number of times at which the combination of a block layer 142 and a quantum level layer 144 is repeated. For example, when the number of repetitions is four, it is indicated that four block layers 142 and four quantum level layers 144 are alternately stacked in the direction from the channel layer 130 and the insulation layer 150. Therefore, the total thickness of the barrier layer 140 is obtained by multiplying the sum of the thickness of one block layer 142 and the thickness of one quantum level layer 144 by the number of repetitions.

### Table 1

### (Attached at the end of the specification)

In Table 1, "144" represents the thickness of one quantum level layer 144, "142" represents the thickness of one block layer 142, "R" represents the number of repetitions, "140" represents the thickness of the barrier layer 140, "142/140" represents the result of "total of the thicknesses of the block layers 142/the thickness of the barrier layer 140", "SR" represents the sheet resistance, "M" represents the mobility, "CD" represents the carrier density, "CR" represents the contact resistance, and "LC" represents the leakage current.

Sample 1, in which the thickness of each of the block layers 142 exceeds 2 nm, has high contact resistance and large leakage current. This is because the resistance is high and many dislocations are generated due to a large thickness of each of the block layers 142. Sample 6, in which the thickness of each of the block layers 142 is equal to or smaller than 0.2 nm, has high contact resistance and large leakage current. This is because the atom arrangement is likely to be disturbed and dislocations are likely to be generated when the thickness of each of the AlN block layers 142 is so thin that the AlN does not form a unit lattice.

Judging from the properties of Samples 1 to 6, the thickness of each of the block layers 142 is preferably larger than 0.2 nm and no more than 2.0 nm, more preferably no less than 0.25 nm and no more than 1.5 nm. Here, the thickness of each of the quantum level layers 144 is preferably no less than 0.6 nm and no more than 6.0 nm. This is because a too thin quantum level layer 144 does not allow a quantum level to be formed. Considering the above, the number of times at which the combination of one block layer 142 and one quantum level layer 144 is repeatedly stacked is preferably no less than four and no more than thirty-one, more preferably, no more than twenty-four.

Sample 7, in which the total of the thicknesses of the block layers 142 included in the barrier layer 140 is smaller than 9 % of the total thickness of the barrier layer 140, exhibits high sheet resistance. This is because, since the composition of the barrier layer 140 is more similar to GaN as a whole, the channel layer 130 has a low carrier density. Sample 11, in which the total of the thicknesses of the block layers 142 included in the barrier layer 140 is larger than 39 % of the total thickness of the barrier layer 140, exhibits large leakage current. This is because more defects are created by the AlN block layers 142. Judging from the properties of Samples 7 to 11, the total of the thicknesses of the block layers 142 included in the barrier layer 140 is preferably no less than 9 % and no more than 39 % of the total thickness of the barrier layer 140, more preferably no less than 15 % and no more than 35 % of the total thickness of the barrier layer 140.

Sample 12, in which the thickness of the barrier layer 140 is no less than 48 nm, exhibits high contact resistance and large leakage current. This is because the barrier layer 140 is thick and thus has high resistance and many defects. Sample 17, in which the thickness of the barrier layer 140 is thinner than 11 nm, has high sheet resistance. This is because the barrier layer 140 is thin and the concentration of the two-dimensional electron gas generated on the channel layer 130 is low. Judging from the properties of Samples 12 to 17, the thickness of the barrier layer 140 is preferably no less than 11 nm and no more than 48 nm, more preferably no less than 15 nm and no more than 40 nm.

Table 2 shows the sheet resistance, carrier mobility, carrier density, contact resistance and leakage current of the SBD 100 when each of the GaN quantum level layers 144 has a thickness of 1.6 nm, and the number of times at which the combination of one AlN block layer 142 and one GaN quantum level layer 144 is repeatedly stacked is twelve. Referring to the block layers 142, except for the lowest one of the block layers 142 that is the closest to the channel layer 130, the other block layers 142 each had the same thickness of 0.55 nm. The lowest one of the block layers 142 that is the closest to the channel layer 130 may have a different thickness than the other block layers 142. Table 2 also shows, for each sample, the thickness of the lowest one of the block layers 142 that is the closest to the channel layer 130. In the SBD 100 relating to the first embodiment, the lowest one of the block layers 142 that is the closest to the channel layer 130 is in contact with the channel layer 130. The other conditions and measuring methods were the same as in the experiment whose results are shown in Table 1.

### Table 2

### (Attached at the end of the specification.)

In Table 2, "142" represents the thickness of the lowest block layer 142, "140" represents the thickness of the barrier layer 140, "142/140" represents the result of "the total of the thicknesses of the block layers 142/the thickness of the barrier layer 140," "SR" represents the sheet resistance, "M" represents the mobility, "CD" represents the carrier density, "CR" represents the contact resistance, and "LC" represents the leakage current.

When the lowest one of the block layers 142 that is the closest to the channel layer 130 has a thickness of no less than 0.75 nm and no more than 1 nm, the sheet resistance takes a minimum value. The sheet resistance increases as the thickness of the lowest lock layer 142 decreases compared with the above range. Sample 18, in which the lowest one of the block layers 142 that is the closest to the channel layer 130 has a thickness of 0.25 nm, has slightly higher sheet resistance. This is because the block layer 142 is thin and the concentration of the two-dimensional electron gas generated on the channel layer 130 is thus low. Sample 24, in which the lowest one of the block layers 142 that is the closest to the channel layer 130 has a thickness of 2 nm or larger, exhibits large leakage current. This is because the block layer 142 is thick and thus has many defects. Additionally, sample 24 exhibits slightly low mobility and slightly high sheet resistance. This is because the block layer 142 is thick and thus has many defects. Accordingly, the lowest one of the block layers 142 that is the closest to the channel layer 130 preferably has a thickness of no more than 1.9 nm, more preferably, no less than 0.25 nm and no more than 1.5 nm, yet more preferably, no less than 0.5 nm and no more than 1.25nm.

Table 3 shows the sheet resistance, carrier mobility, carrier density, contact resistance and leakage current of the SBD 100 when each of the AlN block layers 142 has a thickness of 0.55 nm, and the number of times at which the combination of one AlN block layer 142 and the GaN quantum level layer 144 is repeatedly stacked is twelve. Referring to the quantum level layers 144, except for the highest one of the quantum level layers 144 that is the furthest from the channel layer 130, the other quantum level layers 144 each had the same thickness of 1.60 nm. The highest one of the quantum level layers 144 that is the furthest from the channel layer 130 may have a different thickness than the other quantum level layers 144. Table 3 also shows, for each sample, the thickness of the highest one of the quantum level layers 144. In the SBD 100 relating to the first embodiment, the highest one of the quantum level layers 144 that is the furthest from the channel layer 130 is in contact with the ohmic electrode 160 and the Schottky electrode 170. The other conditions and measuring methods are the same as in the experiment whose results were shown in Table 1.

### Table 3

### (Attached at the end of the specification)

In Table 3, "144" represents the thickness of the highest quantum level layer 144, "140" represents the thickness of the barrier layer 140, "142/140" represents the result of "the total of the thicknesses of the block layers 142/the thickness of the barrier layer 140," "SR" represents the sheet resistance, "M" represents the mobility, "CD" represents the carrier density, "CR" represents the contact resistance, and "LC" represents the leakage current.

Sample 29, in which the highest one of the quantum level layers 144 that is the furthest from the channel layer 130 has a thickness of 15 nm or more, exhibits high contact resistance. This is because the quantum level layer 144 is thick. Sample 29 also exhibits slightly low carrier density and slightly high sheet resistance. This is because, since the composition of the barrier layer 140 is more similar to GaN, the concentration of the two-dimensional electron gas generated on the channel layer 130 is low. Judging from the properties of Samples 25 to 29, as the thickness of the highest one of the quantum level layers 144 increases, the number of crystal defects decreases and the leakage current accordingly decreases. Therefore, the thickness of the highest one of the quantum level layers 144 that is the furthest from the channel layer 130 is preferably no less than 0.5 nm and no more than 14 nm, more preferably no more than 10 nm, yet more preferably no more than 6 nm.

In the SBD 100 relating to the first embodiment, a quantum level layer 144 that is positioned close to the channel layer 130 may have a smaller thickness than a different quantum level layer 144 that is positioned far from the channel layer 130. Here, as the thickness of the quantum level layer 144 decreases, the width of the quantum well decreases and the level formed in the quantum level layer 144 accordingly increases. With the above-described configuration, the gradient of the conduction band for the quantum level layers 144 is gradual towards the surface and small leakage current is thus observed. For example, any given one of the quantum level layers 144 has a larger thickness than any different one of the quantum level layers 144 that is closer to the channel layer 130 than the given quantum level layer 144 and thus positioned below the given quantum level layer 144. Any given one of the quantum level layers 144 may have an equal or larger thickness to/than any different one of the quantum level layers 144 that is closer to the channel layer 130 than the given quantum level layer 144 and thus positioned below the given quantum level layer 144.

The quantum level layers 144 may be divided into a plurality of groups of quantum level layers 144 in such a manner that the quantum level layers 144 in one group all have the same thickness, and the quantum level layers 144 in one of the groups have a larger thickness than the quantum level layers 144 in a different one of the groups that are positioned closer to the channel layer 130. Alternatively, the quantum level layers 144 differ from each other in thickness in such a manner that the thickness of each of the quantum level layers 144 may be larger than the quantum level layer 144 that is immediately adjacent and positioned closer to the channel layer 130. The quantum level layers 144 differ from each other in thickness in such a manner that the thickness of each of the quantum level layers 144 may linearly increase as the position of the quantum level layer 144 moves away from the channel layer 130 from down to top. Alternatively, the difference in thickness between the quantum level layers 144 that are adjacent to each other with a block layer 142 therebetween may gradually increase as the quantum level layers 144 move from the channel layer 130 to the insulation layer 150 from down to top.

The block layers 142 may each have the same thickness. Alternatively, a block layer 142 that is positioned close to the channel layer 130 may have a larger thickness than a different block layer 142 that is positioned far from the channel layer 130. This improves the confinement of the two-dimensional electron gas into the channel layer 130 by the block layers 142, thereby reducing the sheet resistance. For example, any given one of the block layers 142 has a smaller thickness than any different one of the block layers 142 that is positioned closer to the channel layer 130 than the given block layer 142 and thus positioned below the given block layer 142. Any given one of the block layers 142 may have an equal or smaller thickness to/than any different one of the block layers 142 that is positioned closer to the channel layer 130 than the given block layer 142 and thus positioned below the given block layer 142.

The block layers 142 may be divided into a plurality of groups of block layers 142 in such a manner that the block layers 142 in one group have the same thickness, and the block layers 142 in one of the groups may have a smaller thickness than the block layers 142 in a different one of the groups that are positioned closer to the channel layer 130. Alternatively, the block layers 142 differ from each other in thickness in such a manner that the thickness of each of the block layers 142 may be smaller than the block layer 142 that is immediately adjacent and positioned closer to the channel layer 130. The block layers 142 may differ from each other in thickness in such a manner that the thickness of each of the block layers 142 may linearly decrease as the position of the block layer 142 moves away from the channel layer 130 from down to top. Alternatively, the difference in thickness between the block layers 142 that are adjacent to each other with a quantum level layer 144 therebetween may gradually decrease as the block layers 142 move from the channel layer 130 to the insulation layer 150 from down to top.

Table 4 shows examples of the thicknesses of the GaN quantum level layers 144. In the examples shown in Table 4, each of the AlN block layers 142 had the same thickness of 0.5 nm, and the number of times at which the combination of one block layer 142 and one quantum level layer 144 is repeatedly stacked was twelve. In Table 4, the column denoted by "a" indicates the thickness of one of the quantum level layers 144 that is positioned the closest to the channel layer 130. In the order from the column "a" to the column "1," the quantum level layer 144 moves away from the channel layer 130, and the column "1" denotes the thickness of one of the quantum level layers 144 that is positioned the furthest from the channel layer 130.

### Table 4

### (Attached at the end of the specification,)

The SBDs 100 represented as Samples 30, 31 and 32 exhibit 50 % smaller leakage current flowing from the Schottky electrode 170 to the channel layer 130 than the SBD represented as Sample 19. Accordingly, one of the quantum level layers 144 included in the barrier layer 140 that is positioned the furthest from the channel layer 130 preferably has a thickness of no less than 2.5 nm and no more than 10 nm, more preferably no less than 2.5 nm and no more than 6 nm, yet more preferably no less than 2.5 nm and no more than 4 nm. This is because, as described above, the gradient of the conduction band for the quantum level layers 144 is gradual.

Table 5 shows the examples of the thicknesses of the AlN block layers 142 and the thicknesses of the GaN quantum level layers 144. In the examples shown in Table 5, the number of times at which the combination of one block layer 142 and one quantum level layer 144 is repeatedly stacked is twelve. In Table 5, the column denoted by "a" indicates the thickness of one of the block layers 142 that is positioned the closest to the channel layer 130 and the thickness of one of the quantum level layers 144 that is positioned the closest to the channel layer 130. In the order from the column "a" to the column "1," the block layer 142 and the quantum level layer 144 move away from the channel layer 130, and the column "1" denotes the thickness of one of the block layers 142 that is positioned the furthest from the channel layer 130 and the thickness of one of the quantum level layers 144 that is positioned the furthest from the channel layer 130. In other words, in the SBDs 100 shown in Table 5, an AlN block layer 142 having a thickness of 0.75 nm is formed on the channel layer 130, and the insulation layer 150, the ohmic electrode 160 and the Schottky electrode 170 are formed on a GaN quantum level layer 144 having a thickness of 3.0 nm.

### Table 5

### (Attached at the end of the specification)

In Table 5, "144" represents the thickness of the quantum level layer 144 and "142" represents the thickness of the block layer 142.

The SBD 100 represented as Sample 33 exhibits 50 % smaller leakage current from the Schottky electrode 170 to the channel layer 130 and 5% lower sheet resistance than the SBD represented as Sample 19. This is because, as discussed earlier, the gradient of the conduction band for the quantum level layers 144 is gradual and the two-dimensional electron gas is significantly confined to the channel layer 130 by the block layers 142.

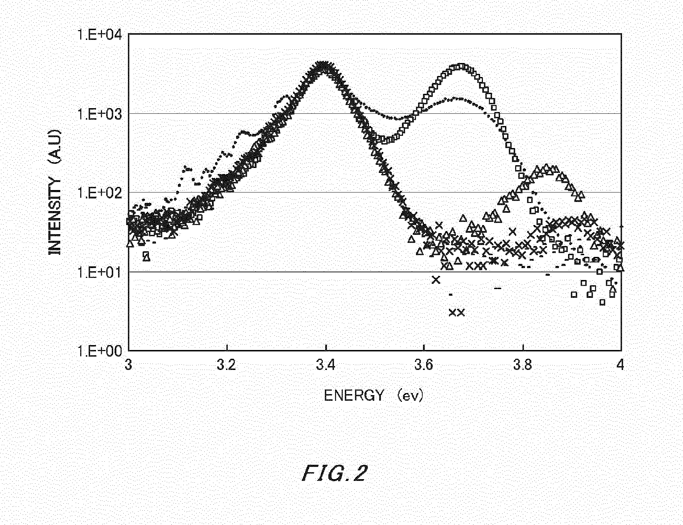

Fig. 2 shows the photoluminescence spectrum of the barrier layer 140 that is observed in response to excitation by ultraviolet beams having a wavelength of 266 nm. In Fig. 2, the white squares correspond to the barrier layer 140 of Sample 1, the black circles correspond to the barrier layer 140 of Sample 2, the white triangles correspond to the barrier layer 140 of Sample 4, the cross marks correspond to the barrier layer 140 of Sample 5, and the short horizontal lines (-) correspond to the barrier layer 140 of Sample 6. The emission peak at approximately 3.4 eV represents the interband transition for GaN. As seen from Fig. 2, emission peaks were observed for the barrier layers 140 at higher energy levels than 3.4 eV. This is because the block layers 142 and the quantum level layers 144 included in the barrier layers 140 form a well potential and a quantum level in the quantum level layers 144.

The intensity of the emission peak at a higher energy than 3.4 eV decreases as the thickness of the block layer 142 decreases, and eventually becomes substantially non-observable when the thickness of the block layer 142 is thinner than 0.25 nm. This is because, when the block layer 142 is too thin, no quantum level is formed. The emission peak at a higher energy than 3.4 eV increases in energy as the thickness of the quantum level layer 144 decreases. This is because, when the quantum level layer 144 is thin, the quantum well has a small width and the quantum level is high. In the SBDs 100 represented as Samples 2 to 4, a quantum level is formed in the quantum level layers 144.

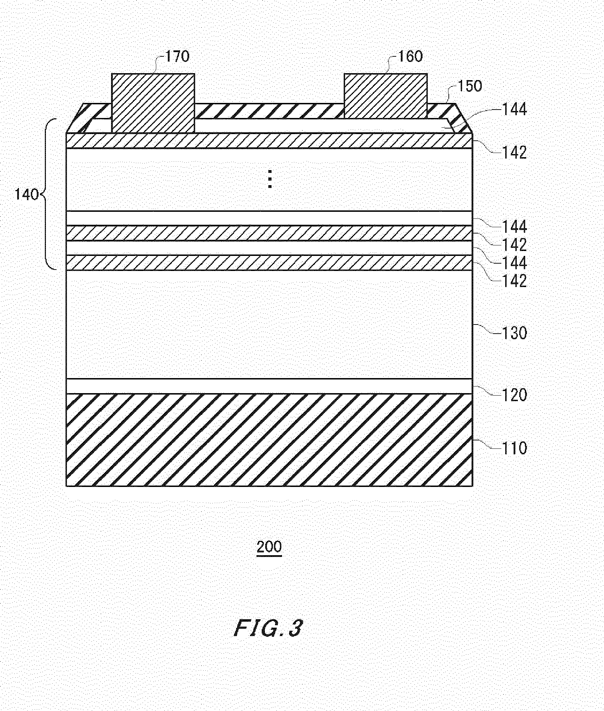

Fig. 3 is a cross-sectional view illustrating a SBD 200 relating to a second embodiment of the present invention. In Fig. 3, the constituents assigned with the same reference numerals as in Fig. 1 may have the same function and configuration as the corresponding constituents described with reference to Fig. 1. The SBD 200 includes the substrate 110, the buffer layer 120, the channel layer 130, the barrier layer 140, the insulation layer 150, the ohmic electrode 160, and the Schottky electrode 170. The barrier layer 140 is formed on the channel layer 130 by stacking the block layers 142 and the quantum level layers 144. The highest one of the quantum level layers 144 that is the furthest from the channel layer 130 is partially removed at the ends of the SBD 200, and the insulation layer 150 may be formed on one of the block layers 142 that is the furthest from the channel layer 130 in the regions from which the highest quantum level layer 144 has been removed.

In the SBD 200 relating to the second embodiment, the highest one of the quantum level levels 144 included in the barrier layer 140 that is the furthest from the channel layer 130 may be partially removed in the region in which the Schottky electrode 170 is formed. The Schottky electrode 170 may be formed on one of the block layers 142 that is the furthest from the channel layer 130 in the region from which the highest quantum level layer 144 that is the furthest from the channel layer 130 has been removed. Since the Schottky electrode 170 is in contact with one of the block layers 142, high Schottky barrier can be formed. This can reduce the leakage current from the Schottky electrode 170 to the channel layer 130.

The insulation layer 150 may be formed on the barrier layer 140, a portion of the insulation layer 150 in which the ohmic electrode 160 is to be formed may be then removed, and the ohmic electrode 160 may be formed on the barrier layer140. The ohmic electrode 160 can be formed, for example, using the lift-off method.

Alternatively, the insulation layer 150, and the highest quantum level layer 144 that is the furthest from the channel layer 130 may be partially removed, and the Schottky electrode 170 may be formed in the region from which the insulation layer 150 and the highest quantum level layer 144 that is the furthest from the channel layer 130 have been removed. When the quantum level layers 144 are made of GaN and the block layers 142 are made of AlN, the highest quantum level layer 144 that is the furthest from the channel layer 130 may be removed using the adjacent block layer 142 as an etch stop layer. The highest quantum level layer 144 may be removed by dry etching using a chlorine series gas. The Schottky electrode 170 may be formed using, for example, the lift-off method.

The Schottky electrode 170 may be formed on the surface of one of the block layers 142 included in the barrier layer 140. In this case, one or more quantum level layers 144 that are formed on or above the block layer 142 whose surface is in contact with the Schottky electrode 170 and, if present, one or more block layers 142 that are positioned above the block layer 142 whose surface is in contact with the Schottky electrode 170 may be partially removed, in the region in which the Schottky electrode 170 is to be formed. In this manner, the height of the Schottky barrier of the Schottky contact can be adjusted.

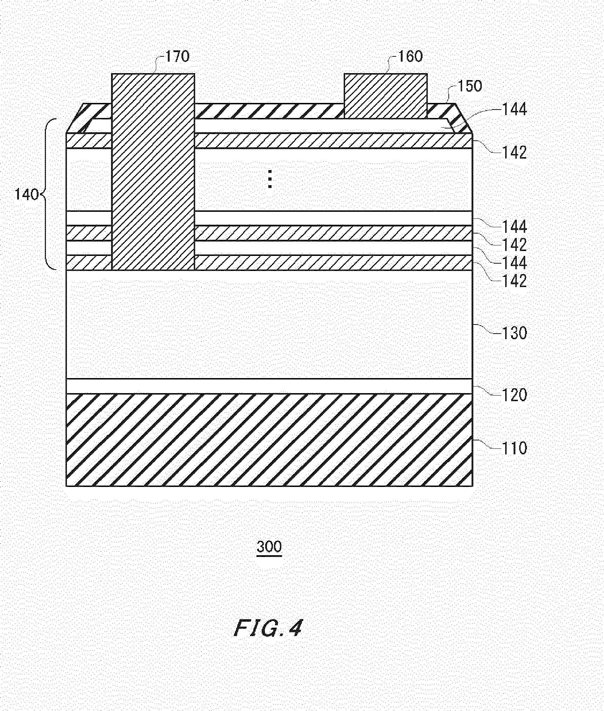

Fig. 4 is a cross-sectional view of a SBD 300 relating to a third embodiment of the present invention. In Fig. 4, the constituents assigned with the same reference numerals as in Fig. 1 may have the same function and configuration as the corresponding constituents described with reference to Fig. 1. The SBD 300 includes the substrate 110, the buffer layer 120, the channel layer 130, the barrier layer 140, the insulation layer 150, the ohmic electrode 160, and the Schottky electrode 170. The barrier layer 140 is formed on the channel layer 130 by stacking the block layers 142 and the quantum level layers 144.

The portion of the barrier layer 140 in which the Schottky electrode 170 is to be formed may be removed. The Schottky electrode 170 may be formed on the channel layer 130 in the region from which the barrier layer 140 has been removed. Since the Schottky electrode 170 is in contact with the channel layer 130, the leakage current from the Schottky electrode 170 to the channel layer 130 is not influenced by the crystal defects in the barrier layer 140. Accordingly, the leakage current can be reduced. The highest one of the quantum level layers 144 that is the furthest from the channel layer 130 is partially removed at the ends of the SBD 200, and the insulation layer 150 may be formed on one of the block layers 142 that is the furthest from the channel layer 130 in the regions from which the highest quantum level layer 144 has been removed.

After the insulation layer 150 is formed on the barrier layer 140, the portion of the insulation layer 150 in which the ohmic electrode 160 is to be formed may be removed so that the ohmic electrode 160 is formed on the barrier layer 140. The ohmic electrode 160 can be formed using, for example, the lift-off method.

The portions of the insulation layer 150 and the barrier layer 140 in which the Schottky electrode 170 is to be formed may be removed, and the Schottky electrode 170 may be then formed. The barrier layer 140 may be removed using dry etching using a chlorine series gas and an argon gas so that the channel layer 130 is exposed. The Schottky electrode 170 is formed on the channel layer 130 using, for example, the lift-off method.

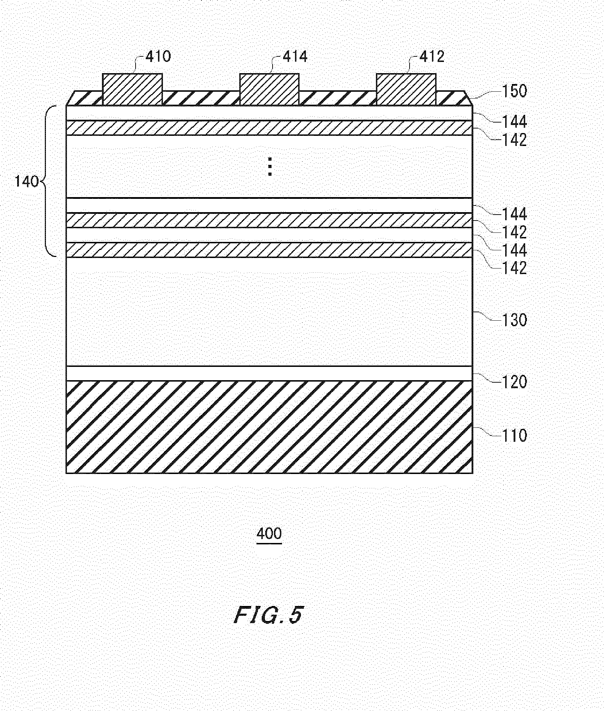

Fig. 5 is a cross-sectional view illustrating a heterojunction field-effect transistor (HFET) 400 relating to a third embodiment of the present invention. In Fig. 5, the constituents assigned with the same reference numerals as in Fig. 1 may have the same function and configuration as the corresponding constituents described with reference to Fig. 1. The HFET 400 includes the substrate 110, the buffer layer 120, the channel layer 130, the barrier layer 140, the insulation layer 150, a source electrode 410, a drain electrode 412 and a gate electrode 414. The barrier layer 140 is formed on the channel layer 130 by stacking the block layers 142 and the quantum level layers 144.

The portions of the insulation layer 150 in which the source electrode 410, the drain electrode 412 and the gate electrode 414 are to be formed may be removed. The source electrode 410, the drain electrode 412, and the gate electrode 414 may be formed on the barrier layer 140 in the regions from which the insulation layer 150 has been removed. The source electrode 410 and the drain electrode 412 may be made of a material that can form an ohmic contact with the channel layer 130. The material for the source electrode 410 and the drain electrode 412 contains, for example, Ti. The source electrode 410 and the drain electrode 412 may be formed on the barrier layer 140 by stacking a Ti layer, an Al layer, and an Au layer in the stated order.

The gate electrode 414 may be made of a material that can form a Schottky contact with the channel layer 130. The material for the gate electrode 414 contains, for example, Ni. The gate electrode 414 may be formed on the barrier layer 140 by stacking an Ni layer and an Au layer in the stated order. The gate electrode 414, the source electrode 410 and the drain electrode 412 can be formed on the barrier layer 140 using sputtering and the lift-off method, but the method of forming the gate electrode 414, the source electrode 410 and the drain electrode 412 is not limited to such.

The heterojunction between the channel layer 130 and one of the block layers 142 generates a two-dimensional electron gas at the interface between the channel layer 130 and the barrier layer 140. The potential of the gate electrode 414 is used to control the two-dimensional electron gas.

The gate electrode 414 may be formed on the surface of one of the block layers 142 included in the barrier layer 140. In this case, one or more quantum level layers 144 that are formed on or above the block layer 142 whose surface is in contact with the gate electrode 414 and, if present, one or more block layers 142 that are positioned above the block layer 142 whose surface is in contact with the gate electrode 414 may be partially removed in the regions in which the gate electrode 414 is to be formed. In this manner, the height of the Schottky barrier of the Schottky contact formed by the gate electrode 414 can be adjusted.

The portion of the barrier layer 140 in which the gate electrode 414 is to be formed is removed, and the gate electrode 414 may be formed on the channel layer 130 in the region from which the barrier layer 140 has been removed. Since the gate electrode 414 is in contact with the channel layer 130, the leakage current from the gate electrode 414 to the channel layer 130 is not influenced by the crystal defects in the barrier layer 140. Accordingly, the leakage current can be reduced.

While the embodiments of the present invention have been described, the technical scope of the invention is not limited to the above described embodiments. It is apparent to persons skilled in the art that various alterations and improvements can be added to the above-described embodiments. It is also apparent from the scope of the claims that the embodiments added with such alterations or improvements can be included in the technical scope of the invention.

The operations, procedures, steps, and stages of each process performed by an apparatus, system, program, and method shown in the claims, embodiments, or diagrams can be performed in any order as long as the order is not indicated by "prior to," "before," or the like and as long as the output from a previous process is not used in a later process. Even if the process flow is described using phrases such as "first" or "next" in the claims, embodiments, or diagrams, it does not necessarily mean that the process must be performed in this order. DESCRIPTION OF

### REFERENCE NUMERALS

100 SBD,110 substrate, 120 buffer layer, 130 channel layer, 140 barrier layer, 142 block layer, 144 quantum level layer, 150 insulation layer, 160 ohmic electrode, 170 Schottky electrode, 200 SBD, 300 SBD, 400 HFET, 410 source electrode, 412 drain electrode, 414 gate electrode

**Table 1**

| SAMPLE | 144 (nm) | 142 (nm) | R | 140 (nm) | 142/140 (nm) | SR (Ω/□) | M (cm²/Vs) | CD (cm⁻³) | CR (Ωcm²) | LC (A) |
|---|---|---|---|---|---|---|---|---|---|---|
| 1 | 6.20 | 2.10 | 3 | 24.9 | 0.253 | 434 | 1250 | 1.2×10¹³ | 4.9×10⁻³ | 8.6×10⁻⁴ |
| 2 | 4.50 | 1.50 | 4 | 24.0 | 0.250 | 418 | 1480 | 1.0×10¹³ | 8.0×10⁻⁵ | 1.0×10⁵ |
| 3 | 2.35 | 0.80 | 8 | 25.2 | 0.254 | 403 | 1630 | 9.5×10¹² | 5.0×10⁻⁶ | 5.1×10⁻⁷ |
| 4 | 1.60 | 0.55 | 12 | 25.8 | 0.256 | 403 | 1685 | 9.2×10¹² | 2.1×10⁻⁶ | 2.6×10⁻⁶ |
| 5 | 0.80 | 0.25 | 24 | 25.2 | 0.238 | 412 | 1460 | 1.0×10¹³ | 2.0×10⁻⁵ | 1.5×10⁻⁵ |
| 6 | 0.55 | 0.20 | 32 | 24.0 | 0.267 | 415 | 1280 | 1.2×10¹³ | 6.1×10⁻⁴ | 1.2×10⁻⁴ |
| 7 | 5.75 | 0.55 | 4 | 25.2 | 0.087 | 1156 | 1800 | 3.0×10¹² | 1.2×10⁻⁴ | 1.1×10⁻⁷ |
| 8 | 3.00 | 0.55 | 7 | 24.9 | 0.155 | 543 | 1770 | 6.5×10¹² | 4.0×10⁻⁶ | 1.8×10⁷ |
| 9 | 1.60 | 0.55 | 12 | 25.8 | 0.256 | 403 | 1685 | 9.2×10¹² | 2.1×10⁻⁶ | 2.6x10⁻⁷ |
| 10 | 1.25 | 0.55 | 14 | 25.2 | 0.306 | 416 | 1500 | 1.0×10¹³ | 2.5×10⁻⁶ | 1.0×10⁻⁶ |
| 11 | 0.85 | 0.55 | 18 | 25.2 | 0.393 | 384 | 1250 | 1.3×10¹³ | 2.0×10⁻⁶ | 1.0×10⁻⁵ |
| 12 | 3.00 | 1.00 | 12 | 48.0 | 0.250 | 455 | 1400 | 9.8×10¹² | 1.0×10⁻⁴ | 8.0×10⁻⁴ |
| 13 | 2.50 | 0.80 | 12 | 39.6 | 0.242 | 438 | 1500 | 9.5×10¹² | 1.2×10⁻⁵ | 5.0×10⁻⁶ |
| 14 | 2.15 | 0.70 | 12 | 34.2 | 0.246 | 415 | 1600 | 9.4×10¹² | 4.0×10⁻⁶ | 2.6×10⁻⁷ |
| 15 | 1.60 | 0.55 | 12 | 25.8 | 0.256 | 403 | 1685 | 9.2×10¹² | 2.1×10⁻⁶ | 2.0×10⁻⁷ |
| 16 | 0.95 | 0.35 | 12 | 15.6 | 0.269 | 470 | 1770 | 7.5×10¹² | 1.8×10⁻⁶ | 1.1×10⁻⁷ |
| 17 | 0.65 | 0.20 | 12 | 10.2 | 0.235 | 1162 | 1790 | 3.0×10¹² | 1.8×10⁻⁶ | 1.0×10⁻⁷ |

**[Table 2]**

| SAMPLE | 142 (nm) | 140 (nm) | 142/140 (nm) | SR (Ω/□) | M (cm²/Vs) | CD (cm⁻³) | CR (Ωcm²) | LC (A) |
|---|---|---|---|---|---|---|---|---|
| 18 | 0.25 | 26.1 | 0.256 | 490 | 1500 | 8.5×10¹² | 1.5×10⁻⁶ | 3.0×10⁻⁷ |
| 19 | 0.5 | 26.3 | 0.256 | 403 | 1685 | 9.2×10¹² | 2.1×10⁻⁶ | 2.6×10⁻⁷ |
| 20 | 0.75 | 26.6 | 0.249 | 379 | 1750 | 9.4×10¹² | 4.0×10⁻⁶ | 3.5×10⁻⁷ |
| 21 | 1 | 26.8 | 0.256 | 382 | 1720 | 9.5×10¹² | 1.0×10⁻⁵ | 5.0×10⁻⁷ |
| 22 | 1.25 | 27.1 | 0.256 | 387 | 1680 | 9.6×10¹² | 3.0×10⁻⁵ | 2.0×10⁻⁶ |
| 23 | 15 | 27.3 | 0.256 | 402 | 1600 | 9.7×10¹² | 8.0×10⁻⁵ | 8.0×10⁻⁶ |
| 24 | 2 | 27.8 | 0.256 | 455 | 1400 | 9.8×10¹² | 6.0×10⁻³ | 2.0×10⁻⁴ |

**[Table 3]**

| SAMPLE | 144 (nm) | 140 (nm) | 142/140 (nm) | SR (Ω/□) | M (cm²/Vs) | CD (cm⁻³) | CR (Ωcm²) | LC (A) |
|---|---|---|---|---|---|---|---|---|
| 25 | 0.5 | 27.1 | 0.256 | 380 | 1730 | 9.5×10¹² | 4.0×10⁻⁶ | 3.5×10⁻⁷ |
| 26 | 3 | 29.6 | 0.256 | 379 | 1700 | 9.7×10¹² | 3.0×10⁻⁸ | 8.8×10⁻⁸ |
| 27 | 6 | 32.6 | 0.256 | 394 | 1740 | 9.1×10¹² | 5.0×10⁻⁶ | 3.0×10⁻⁸ |
| 28 | 10 | 36.6 | 0.181 | 415 | 1770 | 8.5×10¹² | 5.0×10⁻⁵ | 8.1×10⁻⁹ |
| 29 | 15 | 41.6 | 0.256 | 540 | 1780 | 6.5x10¹² | 2.0×10⁻³ | 4.1×10⁻⁹ |

**[Table 4]**

| SAMPLE | CHANNEL LAYER 130 ← | | | | | | | | → INSULATION LAYER 150 | | | |
|---|---|---|---|---|---|---|---|---|---|---|---|---|
| | a | b | c | d | e | f | g | h | i | j | k | l |
| 30 | 0.3 nm | 0.5 nm | 0.8 nm | 1.0 nm | 1.3 nm | 1.5 nm | 1.8 nm | 2.0 nm | 2.3 nm | 2.5 nm | 2.8 nm | 3.0 nm |
| 31 | 0.5 nm | 0.5 nm | 0.5 nm | 0.5 nm | 1.5 nm | 1.5 nm | 1.5 nm | 1.5 nm | 2.5 nm | 2.5 nm | 2.5 nm | 2.5 nm |
| 32 | 0.3 nm | 0.4 nm | 0.5 nm | 0.6 nm | 0.8 nm | 1 nm | 1.2 nm | 1.6 nm | 2 nm | 2.5 nm | 3.2 nm | 4 nm |

**[Table 5]**

| SAMPLE 33 | a | b | c | d | e | f | g | h | i | j | k | l |
|---|---|---|---|---|---|---|---|---|---|---|---|---|
| | CHANNEL LAYER 130 ← | | | | | | | | → INSULATION LAYER 150 | | | |
| 144 (nm) | 0.3 | 0.5 | 0.8 | 1.0 | 1.3 | 1.5 | 1.8 | 2.0 | 2.3 | 2.5 | 2.8 | 3.0 |
| 142 (nm) | 0.75 | 0.75 | 0.75 | 0.75 | 0.5 | 0.5 | 0.5 | 0.5 | 0.25 | 0.25 | 0.25 | 0.25 |

## Claims

1. A semiconductor device comprising:
a substrate;
a channel layer that is formed above the substrate, the channel layer being made of a first nitride series compound semiconductor;
a barrier layer that is formed on the channel layer;
a first electrode that is formed on the barrier layer; and
a second electrode that is formed above the channel layer, wherein
the barrier layer includes block layers and quantum level layers alternately stacked on each other,
one of the block layers is formed on the channel layer and the block layers are made of a second nitride series compound semiconductor having a larger band gap energy than the first nitride series compound semiconductor, and
the quantum level layers are formed on the block layers, made of a third nitride series compound semiconductor having a smaller band gap energy than the second nitride series compound semiconductor, and each have a quantum level formed therein.

2. The semiconductor device as set forth in Claim 1, wherein
the second nitride series compound semiconductor is AlN, and
the third nitride series compound semiconductor is GaN.

3. The semiconductor device as set forth in one of Claims 1 and 2, wherein
the barrier layer has a thickness of no less than 15 nm and no more than 40 nm, and
the block layers each have a thickness of no less than 0.25 nm and no more than 1.5 nm.

4. The semiconductor device as set forth in one of Claims 1 to 3, wherein
a total of thicknesses of the block layers included in the barrier layer is 15 % or more of a thickness of the barrier layer.

5. The semiconductor device as set forth in one of Claims 1 to 4, wherein
one of the block layers included in the barrier layer that is the closest to the channel layer has a thickness of no less than 0.5 nm and no more than 1.5 nm.

6. The semiconductor device as set forth in one of Claims 1 to 5, wherein
one of the block layers included in the barrier layer that is the closest to the channel layer has a different thickness than the other block layers.

7. The semiconductor device as set forth in one of Claims 1 to 6, wherein
one of the quantum level layers included in the barrier layer that is the furthest from the channel layer has a thickness of no less than 0.5 nm and no more than 10 nm.

8. The semiconductor device as set forth in one of Claims 1 to 6, wherein
one of the quantum level layers included in the barrier layer that is the furthest from the channel layer has a thickness of no less than 2.5 nm and no more than 10 nm.

9. The semiconductor device as set forth in one of Claims 1 to 8, wherein
one of the quantum level layers included in the barrier layer that is the furthest from the channel layer has a different thickness than the other quantum level layers.

10. The semiconductor device as set forth in one of Claims 1 to 8, wherein
one of the quantum level layers has a larger thickness than a different one of the quantum level layers that is closer to the channel layer.

11. The semiconductor device as set forth in one of Claims 1 to 10, wherein
one of the quantum level layers has an equal or larger thickness to/than a different one of the quantum level layers that is closer to the channel layer.

12. The semiconductor device as set forth in one of Claims 1 to 11, wherein
the quantum level layers are divided into a plurality of groups in such a manner that the quantum level layers in a given one of the plurality of groups have the same thickness, and
the quantum level layers included in one of the plurality of groups have a larger thickness than the quantum level layers included in a different one of the plurality of groups that are closer to the channel layer.

13. The semiconductor device as set forth in one of Claims 1 to 9, wherein
a given one of the quantum level layers has a smaller thickness than a different one of the quantum level layers that is further from the channel layer than the given quantum level layer.

14. The semiconductor device as set forth in one of Claims 1 to 13, wherein
one of the block layers has a smaller thickness than a different one of the block layers that is closer to the channel layer.

15. The semiconductor device as set forth in one of Claims 1 to 14, wherein
one of the block layers has an equal or smaller thickness to/than a different one of the block layers that is closer to the channel layer.

16. The semiconductor device as set forth in one of Claims 1 to 15, wherein
the first electrode forms an ohmic contact with the channel layer, and
the second electrode forms an Schottky contact with the channel layer.

17. The semiconductor device as set forth in Claim 16, further comprising
a third electrode that is formed on the barrier layer and forms an ohmic contact with the channel layer.

18. The semiconductor device as set forth in one of Claims 16 and 17, wherein
the second electrode is in contact with a surface of one of the block layers.

19. The semiconductor device as set forth in one of Claims 16 and 17, wherein
the second electrode is in contact with the channel layer.
